# EUROPEAN PATENT APPLICATION

(11) **EP 2 416 381 A1**
(43) Date of publication of application: **08.02.2012**
(21) Application number: 10761338.2
(22) Date of filing: 19.03.2010
(51) Int. Cl.: H01L 31/042, B32B 27/30

(54) **PROTECTIVE SHEET FOR SOLAR CELL MODULE AND SOLAR CELL MODULE**

(30) Priority: 30.03.2009 JP 2009083504
(71) Applicant: LINTEC Corporation, Tokyo 173-0001 (JP)
(72) Inventor: SUGIURA, Shogo, Tokyo 173-0001 (JP); KATO, Kiichiro, Tokyo 173-0001 (JP)
(74) Representative: Jansen, Cornelis Marinus
(86) International application number: PCT/JP2010/002006
(87) International publication number: WO 2010/116630

(57) **Abstract**

A protective sheet for a solar cell module prepared by forming an acrylic urethane resin layer on one surface or both surfaces of a base sheet. The acrylic urethane resin layer is preferably formed on the opposite surface of the base sheet to the surface that contacts an encapsulant.

## Description

### TECHNICAL FIELD

The present invention relates to a protective sheet for a solar cell module, and a solar cell module provided with the protective sheet.
Priority is claimed on Japanese Patent Application No. 2009-083504, filed March 30, 2009, the content of which is incorporated herein by reference.

### BACKGROUND ART

Solar cell modules, which are devices for converting the energy from sunlight into electrical energy, are attracting much attention as systems that are capable of generating electricity without discharging carbon dioxide. These solar cell modules require a high level of electric power generation efficiency, as well as a level of durability that enables the module to be used for long periods, even when used outdoors.
The main structure of a solar cell module is composed of solar cell that function as the photovoltaic elements, an encapsulant which is an electrical insulator that prevents shorts within the electrical circuits, and a protective sheet that protects the solar cell and the encapsulant. It is generally thought that improving the performance of the protective sheet is an important factor in enhancing the durability of the solar cell module.

In those cases where a solar cell module is used over a long period, in order to prevent current leakage and corrosion within the electrical circuits inside the solar cell module, the protective sheet for the solar cell module must exhibit superior water vapor barrier properties and weather resistance.
Conventionally, halogen compounds such as fluororesin films and fluororesin coatings have been used as materials for imparting the protective sheet with enhanced weather resistance (see Patent Document 1).
Patent Document 1 discloses a back sheet for a solar cell module prepared by forming a cured coating film of a curable functional group-containing, fluorine-containing coating material on at least one surface of a water-impermeable sheet.

### PRIOR ART DOCUMENTS

### PATENT DOCUMENTS

[Patent Document 1] International Patent Publication No. 2007/010706 pamphlet

### DISCLOSURE OF INVENTION

### PROBLEMS TO BE SOLVED BY THE INVENTION

However, solar cell module protective sheets containing a halogen compound tend to generate toxic substances when incinerated, and because their environmental impact is significant, the use of such halogen compounds is undesirable from the viewpoint of waste disposal.
Further, fluororesins are expensive, resulting in increased costs for the solar cell module protective sheet and the solar cell module provided with the protective sheet.

The present invention takes the above circumstances into consideration, with an object of providing a protective sheet for a solar cell module that has minimal environmental impact and exhibits excellent adhesion to a base sheet.

### MEANS TO SOLVE THE PROBLEMS

In order to achieve the above object, the present invention provides a protective sheet for a solar cell module, the protective sheet prepared by forming an acrylic urethane resin layer on one surface or both surfaces of a base sheet.

In the present invention, the acrylic urethane resin layer is preferably formed on the opposite surface of the base sheet to the surface that contacts an encapsulant.

In the present invention, the acrylic urethane resin layer is preferably formed from a resin obtained by mixing and reacting an acrylic polyol and a polyisocyanate.

In the present invention, the above-mentioned acrylic polyol preferably has a weight-average molecular weight within a range from 5,000 to 300,000 and a glass transition temperature within a range from 30 to 80°C.

In the present invention, the hydroxyl value of the acrylic polyol is preferably within a range from 25 to 150 mgKOH/g (for the solid fraction).

In the present invention, the acrylic polyol is preferably a polyester-modified acrylic polyol.

In the present invention, the acrylic polyol preferably includes one or both of an ultraviolet-stabilizing group and an ultraviolet-absorbing group within the molecule.

In the present invention, the molar ratio within the above-mentioned acrylic urethane resin layer between the isocyanate groups of the polyisocyanate component and the hydroxyl groups of the acrylic polyol component ([NCO]/[OH]) is preferably within a range from 0.5 to 1.5.

In the present invention, the polyisocyanate is preferably a hexamethylene diisocyanate-based polyisocyanate, and preferably includes one or more polyisocyanates selected from the group consisting of biuret-type, isocyanurate-type, adduct-type, difunctional prepolymer-type and block-type polyisocyanates.

In the present invention, the acrylic urethane resin layer is preferably laminated to one surface of the above-mentioned base sheet, and an adhesive layer, composed of one material selected from the group consisting of ethylene-vinyl acetate copolymers, ethylene-methacrylic acid copolymers, ionomer resins prepared by cross-linking molecules of an ethylene-methacrylic acid copolymer with metal ions, and mixtures thereof, is laminated to the other surface of the base sheet with a laminate adhesive layer disposed therebetween.

In the present invention, the acrylic urethane resin layer is preferably laminated to one surface of the base sheet, an aluminum layer is laminated to the other surface of the base sheet with a laminate adhesive layer disposed therebetween, and an adhesive layer, composed of one material selected from the group consisting of ethylene-vinyl acetate copolymers, ethylene-methacrylic acid copolymers, ionomer resins prepared by cross-linking molecules of an ethylene-methacrylic acid copolymer with metal ions, and mixtures thereof, is laminated to the aluminum layer with a laminate adhesive layer disposed therebetween.

Further, the present invention also provides a solar cell module having the above-mentioned protective sheet for a solar cell module bonded thereto.

### EFFECT OF THE INVENTION

The protective sheet for a solar cell module according to the present invention contains no halogen substances (containing fluorine or chlorine) that have a significant impact on the environment, and therefore the generation of toxic substances upon incineration can be inhibited.
Further, by using an acrylic urethane resin layer, the adhesion to the base sheet (both in terms of initial adhesion and long-term durability) can be improved, meaning problems such as peeling of the acrylic urethane resin layer are unlikely to occur.
Accordingly, the protective sheet of the present invention can be used favorably as a protective sheet for solar cell modules.

### BRIEF DESCRIPTION OF THE DRAWINGS

FIG. 1 is a schematic view illustrating a cross-section of a first embodiment of a protective sheet for a solar cell module according to the present invention.
FIG. 2 is a schematic view illustrating a cross-section of a second embodiment of a protective sheet for a solar cell module according to the present invention.
FIG. 3 is a schematic view illustrating the structure of a solar cell module according to the present invention.

### BEST MODE FOR CARRYING OUT THE INVENTION

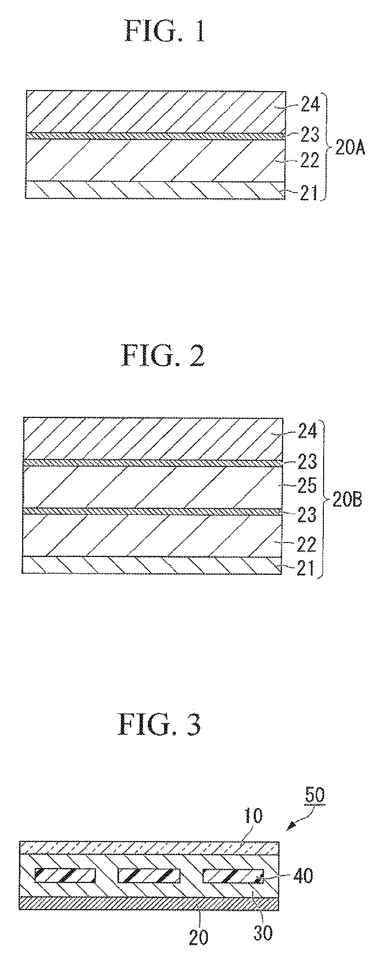

FIG. 3 is a schematic view illustrating the structure of a solar cell module that includes a protective sheet for a solar cell module according to the present invention.
As illustrated in FIG. 3, the structure of a solar cell module 50 including the protective sheet of the present invention includes a front surface protective sheet 10, a back surface protective sheet 20, an encapsulant 30, and solar cell 40. In order to impart the solar cell module with the weather resistance and durability necessary to enable the module to be used for long periods outdoors and indoors, the solar cell 40 and the encapsulant 30 must be protected from heavy rain, moisture, dust, and mechanical impacts and the like, and the interior of the solar cell module must be maintained in a sealed state that completely blocks out the external environment. As a result, the front surface protective sheet 10 and the back surface protective sheet 20 must exhibit favorable weather resistance.

FIG. 1 is a schematic view illustrating a cross-section of a first embodiment of a protective sheet for a solar cell module (hereinafter abbreviated as "the protective sheet") according to the present invention.
FIG. 1 and FIG. 2, which is described below, illustrate examples in which the protective sheet of the present invention is used as the back surface protective sheet 20, but the protective sheet of the present invention may also be used as the front surface protective sheet 10. In those cases where an aluminum layer or a layer containing a white pigment such as titanium dioxide is laminated to a base sheet 22, the protective sheet of the present invention is used as the back surface protective sheet 20, whereas in those cases where the protective sheet is used as the front surface protective sheet 10, a transparent base sheet is used.
A protective sheet 20A of the present embodiment has a structure in which an acrylic urethane resin layer 21 is laminated to one surface of the base sheet 22, and an adhesive layer 24 is laminated to the other surface of the base sheet 22 with a laminate adhesive layer 23 disposed therebetween.

Examples of resin sheets that can be used as the base sheet 22 include the types of resin sheets typically used in protective sheets for solar cell modules. Specific examples include sheets formed from polymers such as polyethylene, polypropylene, polystyrene, poly(methyl methacrylate), polytetrafluoroethylene, polyamide (Nylon 6, Nylon 66), polyacrylonitrile, polyvinyl chloride, polyethylene terephthalate (PET), polybutylene terephthalate (PBT), polyethylene naphthalate (PEN), polyoxymethylene, polycarbonate, polyphenylene oxide, polyester urethane, poly(m-phenylene isophthalamide) and poly(p-phenylene terephthalamide). Of these, sheets formed from a polyester are preferred, and from the viewpoints of achieving favorable mechanical strength and favorable insulating properties, PET sheets, PBT sheets and PEN sheets are particularly desirable.

The thickness of the base sheet 22 may be selected on the basis of the electrical insulation properties required by the solar cell system. For example, in those cases where the base sheet 22 is a resin sheet, a thickness within a range from 10 to 300 µm is preferred. More specifically, if the base sheet 22 is a PET sheet, then from the viewpoints of lightening the weight and ensuring good electrical insulation properties, the thickness of the PET sheet is preferably within a range from 10 to 300 µm, more preferably from 30 to 200 µm, and still more preferably from 50 to 125 µm.

Further, from the viewpoint of enhancing the water vapor barrier properties, the base sheet 22 may be subjected to a surface modification treatment. For example, by vapor deposition of silica (SiO₂) and/or alumina (Al₂O₃) on the surface of the above-mentioned PET sheet, the weather resistance and moisture resistance and the like of the protective sheet can be improved. The vapor deposition of silica and/or alumina may be performed either on both surfaces of the base sheet 22, or on only one of the sheet surfaces.
From the viewpoint of the water vapor barrier properties, a sheet formed from a metallic foil such as an aluminum foil or an aluminum-iron alloy foil, an aluminum-vapor deposited PET sheet, or an aluminum foil-laminated PET sheet or the like may also be used as the base sheet 22.

The acrylic urethane resin used as the acrylic urethane resin layer 21 is preferably a resin obtained by mixing and reacting an acrylic polyol that represents the main component and a polyisocyanate that functions as a cross-linking agent.

The acrylic polyol that represents the main component of the acrylic urethane resin preferably has a weight-average molecular weight within a range from 5,000 to 300,000 and a glass transition temperature within a range from 30 to 80°C. Further, the hydroxyl value of this acrylic polyol is preferably within a range from 25 to 150 mgKOH/g (for the solid fraction). Examples of acrylic polyols having these types of properties include any of the various acrylic polyols obtained by performing a radical copolymerization of an acrylic monomer containing a hydroxyl group and another copolymerizable monomer containing an unsaturated double bond. In the present invention, a polyester-modified acrylic polyol is particularly desirable as the acrylic polyol.

Examples of the polyisocyanate that functions as the cross-linking agent for the acrylic urethane resin include various polyisocyanates, including aromatic diisocyanates such as 2,4-tolylene diisocyanate, 2,6-tolylene diisocyanate, 4,4'-diphenylmethane diisocyanate, 2,4'-diphenylmethane diisocyanate, 2,2'-diphenylmethane diisocyanate and 4,4'-diphenyl ether diisocyanate, aliphatic diisocyanates such as hexamethylene diisocyanate (HMDI), tetramethylene diisocyanate, 2-methyl-pentane-1,5-diisocyanate, 3-methyl-pentane-1,5-diisocyanate, lysine diisocyanate and trioxyethylene diisocyanate, aromatic aliphatic diisocyanates such as xylylene-1,4-diisocyanate, xylylene-1,3-diisocyanate (XDI) and tetramethylxylylene diisocyanate, and alicyclic diisocyanates such as isophorone diisocyanate, hydrogenated tolylene diisocyanate, hydrogenated xylylene diisocyanate, hydrogenated diphenylmethane diisocyanate and hydrogenated tetramethylxylylene diisocyanate, as well as nurate forms and biuret forms of the above compounds. Any of the above compounds may be used individually, or two or more compounds may be used in combination. In the present invention, the polyisocyanate is preferably a hexamethylene diisocyanate-based polyisocyanate including one or more polyisocyanates selected from the group consisting of biuret-type, isocyanurate-type, adduct-type, difunctional prepolymer-type and block-type polyisocyanates.

In the acrylic urethane resin, the molar ratio between the isocyanate groups of the polyisocyanate component and the hydroxyl groups of the acrylic polyol component ([NCO]/[OH]) is preferably within a range from 0.5 to 1.5.

A coating liquid of the acrylic urethane resin can be prepared by mixing the acrylic polyol that represents the main component, the polyisocyanate that functions as the cross-linking agent and an organic solvent, and this coating liquid can then be applied to the base sheet 22 using a bar coater or the like and subsequently heated at a temperature of at least 70°C, and preferably a temperature of approximately 80 to 150°C, for a period of approximately 0.5 to 5 minutes. Specific examples of the organic solvent include ketones such as methyl ethyl ketone, C9 to C12 alkylcyclohexanes such as methylcyclohexane, ethylcyclohexane and dimethylcyclohexane, ethers such as propylene glycol monomethyl ether acetate, propylene glycol monomethyl ether propionate, diethylene glycol monoethyl ether acetate, diethylene glycol monobutyl ether acetate and dipropylene glycol dimethyl ether, and esters such as ethyl acetate and butyl acetate. These organic solvents may be used individually or in combinations containing two or more solvents.

Besides the acrylic urethane resin described above, the acrylic urethane resin layer 21 may also contain additives such as fillers, pigments, ultraviolet absorbers, ultraviolet stabilizers, flame retardants, plasticizers, crystal nucleation agents, hydrochloric acid absorbers, antistatic agents, inorganic fillers, lubricants and antiblocking agents, which may be added according to need.
There are no particular limitations on the fillers and/or pigments, provided they do not impair the effects of the present invention. Examples include titanium dioxide, carbon black, perylene pigments, colorants, dyes, mica, polyamide powder, boron nitride, zinc oxide, aluminum oxide, silica and ultraviolet absorbers. More specific examples of preferred materials include Ti-Pure R105 (a product name, manufactured by E. I. du Pont de Nemours and Company), which is a rutile titanium dioxide that has been treated with silicon dioxide to impart durability, and CAB-O-SIL TS-720 (a product name, manufactured by Cabot Corporation), which is a hydrophobic silica in which the hydroxyl groups at the silica surface have been modified via a dimethylsilicone surface treatment.
Examples of the ultraviolet absorbers include benzophenone-based compounds, benzotriazole-based compounds, oxanilide-based compounds, cyanoacrylate-based compounds and triazine-based compounds.

In order to impart the acrylic urethane resin layer 21 with satisfactory weather resistance, an ultraviolet absorber or ultraviolet stabilizer is preferably added to the resin layer.
Further, from the viewpoint of preventing bleed out and the like (and imparting long-term weather resistance), rather than adding a low-molecular weight ultraviolet absorber or a low-molecular weight ultraviolet stabilizer to the resin, a polymer that includes one or both of an ultraviolet-stabilizing group and an ultraviolet-absorbing group within the polymer structure is preferred. Accordingly, it is preferable that an acrylic polyol having one or both of an ultraviolet-stabilizing group and an ultraviolet-absorbing group within the molecule is used in forming the acrylic urethane resin layer 21.

An acrylic polyol having one or both of an ultraviolet-stabilizing group (hereinafter referred to as HALS) and an ultraviolet-absorbing group (hereinafter referred to as UVA) within the molecule can be obtained by copolymerization of an HALS-containing monomer and/or a UVA-containing monomer with one or more other copolymerizable monomers.

Examples of the HALS-containing monomer include hindered amine-based compounds containing at least one sterically hindered amino group and at least one polymerizable unsaturated bond within each molecule, and specific examples include 4-(meth)acryloyloxy-2,2,6,6-tetramethylpiperidine, 4-(meth)acryloylamino-2,2,6,6-tetramethylpiperidine, 4-(meth)acryloyloxy-1,2,2,6,6-pentamethylpiperidine, 4-(meth)acryloylamino-1,2,2,6,6-pentamethylpiperidine, 4-cyano-4-(meth)acryloylamino-2,2,6,6-tetramethylpiperidine, 1-(meth)acryloylamino-4-(meth)acryloylamino-2,2,6,6-tetramethylpiperidine, 4-crotonoyloxy-2,2,6,6-tetramethylpiperidine and 1-crotonoyloxy-2,2,6,6-tetramethylpiperidine. Any of these compounds may be used individually, or two or more compounds may be mixed appropriately and used in combination.

Examples of the UVA-containing monomer include 2-[2'-hydroxy-3'-(meth)acryloylaminophenyl]-2H-benzotriazole, 2-[2'-hydroxy-3'-(meth)acryloylaminomethylphenyl]-2H-benzotriazole, 2 [2'-hydroxy-3'-(meth)acryloylamino-5'-tert-octylphenyl]-2H-benzotriazole, 2-[2'-hydroxy-3'-(meth)acryloylaminomethyl-5'-tert-octylphenyl]-2H-benzotriazole, 2-[2'-hydroxy-3'-tert-octyl-5'-(meth)acryloylaminophenyl]-2H-benzotriazole, 2-[2'-hydroxy-3'-tert-octyl-5'-(meth)acryloylaminomethylphenyl]-2H-benzotriazole, and 2-[2'-hydroxy-5'-(3-(meth)acryloyloxy-2-hydroxypropoxy)-3'-tert-butylphenyl]-2H-benzotriazole. Any of these compounds may be used individually, or two or more compounds may be mixed appropriately and used in combination.

Further, examples of the other copolymerizable monomers include cycloalkyl group-containing polymerizable monomers such as cyclohexyl (meth)acrylate, methylcyclohexyl (meth)acrylate and tert-butylcyclohexyl (meth)acrylate, hydroxyl group-containing polymerizable monomers such as hydroxyethyl (meth)acrylate, hydroxypropyl (meth)acrylate, hydroxybutyl (meth)acrylate and caprolactone-modified hydroxy (meth)acrylate, acid group-containing unsaturated monomers such as (meth)acrylic acid, maleic acid and 2-(meth)acryloylethyl acid phosphate, alkyl (meth)acrylates such as methyl (meth)acrylate, ethyl (meth)acrylate, propyl (meth)acrylate, isopropyl (meth)acrylate, butyl (meth)acrylate, tert-butyl (meth)acrylate, stearyl (meth)acrylate, lauryl (meth)acrylate and 2-ethylhexyl (meth)acrylate, epoxy group-containing unsaturated monomers such as glycidyl (meth)acrylate, nitrogen-containing unsaturated monomers such as (meth)acrylamide, N,N'-dimethylaminoethyl (meth)acrylate, N,N'-dimethylaminopropyl acrylamide, vinylpyridine and vinylimidazole, aromatic unsaturated monomers such as styrene, α-methylstyrene and vinyltoluene, vinyl esters such as vinyl acetate, vinyl ethers, unsaturated cyano compounds such as (meth)acrylonitrile, and silicon-containing unsaturated monomers such as vinyltrimethoxysilane and γ-methacryloxypropylmethoxysilane.

Examples of the method used for copolymerizing the HALS-containing monomer and/or UVA-containing monomer and the other copolymerizable monomers include conventional methods such as solution polymerization methods, emulsion polymerization methods, suspension polymerization methods and bulk polymerization methods. Examples of solvents that may be used in the case where a solution polymerization method is employed include aromatic hydrocarbons such as xylene, ketones, alcohols and esters, and any of these solvents may be used individually or as a mixed solvent. Further, typically used radical polymerization initiators such as azobisisobutyronitrile, benzoyl peroxide and butyl peroxide may be used as a polymerization initiator.

By mixing the acrylic polyol containing HALS and/or UVA obtained in the manner described above with the polyisocyanate that functions as the cross-linking agent and an organic solvent to prepare a coating liquid, subsequently applying the coating liquid to the base sheet 22 using a bar coater or the like, and then performing heating, a coating of an acrylic urethane resin containing HALS and/or UVA can be formed.

In terms of the adhesive layer 24 that is laminated to the other surface of the base sheet 22, if the protective sheet is to be laminated to the back surface of a solar cell module 50 and used as a back surface protective sheet, then from the viewpoint of improving the adhesion to the encapsulant 30, the adhesive layer 24 is preferably an acrylic urethane resin, an ethylene-vinyl acetate copolymer (EVA), an ethylene-methacrylic acid copolymer, or an ionomer resin prepared by cross-linking molecules of an ethylene-methacrylic acid copolymer with metal ions. Moreover, in order to enable thermal adhesion with the encapsulant 30, the adhesive layer 24 preferably exhibits thermal adhesiveness. In this description, the expression "thermal adhesiveness" describes a property wherein the sheet exhibits adhesiveness when subjected to a heat treatment. The temperature of the heat treatment is typically within a range from 50 to 200°C. In terms of improving the adhesiveness, the adhesive layer 24 is preferably a resin composed of one material selected from the group consisting of ethylene-vinyl acetate copolymers (EVA), ethylene-methacrylic acid copolymers (EMAA), ionomer resins, and mixtures thereof. The encapsulant 30 is often a resin formed from EVA, and in such cases, by forming the adhesive layer 24 from a resin composed of a polymer containing EVA as the main component, the adhesion between the encapsulant30 and the adhesive layer 24 can be improved.

There are no particular limitations on the thickness of the adhesive layer 24 provided the thickness does not impair the effects of the present invention. Specifically, if the base resin of the adhesive layer 24 is EVA, then from the viewpoints of achieving favorable lightweight properties and electrical insulation properties, the thickness of the adhesive layer 24 is preferably within a range from 10 to 200 µm, and more preferably from 20 to 150 µm.

If required, other polymers or various compounding agents may also be added to the adhesive layer 24.
Examples of other polymers that may be used include flexible polymers and other organic polymer-based fillers.
Further, examples of the various compounding agents that may be added include both organic compounds and inorganic compounds that are typically used in the resins industry. Examples of these compounding agents include age resisters, stabilizers, pigments such as titanium dioxide, flame retardants, plasticizers, crystal nucleation agents, hydrochloric acid absorbers, antistatic agents, inorganic fillers, lubricants, antiblocking agents and ultraviolet absorbers.

There are no particular limitations on the adhesive contained within the laminate adhesive layer 23 that is used for bonding the base sheet 22 and the adhesive layer 24, provided the adhesive enables strong bonding between the base sheet 22 and the adhesive layer 24, and examples of the adhesive include acrylic adhesives, urethane-based adhesives, epoxy-based adhesives and ester-based adhesives. Any of these adhesives may be used individually, or to or more adhesives may be used in combination.

The protective sheet 20A of the present embodiment contains no halogen substances (containing fluorine or chlorine) that have a significant impact on the environment, and therefore the generation of toxic substances upon incineration can be inhibited.
Further, by using the acrylic urethane resin layer 21, the adhesion to the base sheet 22 (both in terms of initial adhesion and long-term durability) can be improved, meaning problems such as peeling of the acrylic urethane resin layer 21 are unlikely to occur.
Accordingly, the protective sheet 20A can be used favorably as a protective sheet for solar cell modules.

FIG. 2 is a schematic view illustrating a cross-section of a second embodiment of a protective sheet for a solar cell module according to the present invention.
A protective sheet 20B of this embodiment has a structure in which an acrylic urethane resin layer 21 is laminated to one surface of a base sheet 22, an aluminum layer 25 is laminated to the other surface of the base sheet 22 with a laminate adhesive layer 23 disposed therebetween, and an adhesive layer 24 is laminated to the aluminum layer 25 with a laminate adhesive layer 23 disposed therebetween. In this embodiment, the acrylic urethane resin layer 21, the base sheet 22, the laminate adhesive layer 23 and the adhesive layer 24 may use the same materials as those described above for the first embodiment.

The aluminum layer 25 is formed for the purposes of reducing the water vapor permeability and improving the moisture resistance of the protective sheet 20B. There are no particular limitations on the thickness of the aluminum layer 25, provided a satisfactory moisture resistance improvement effect can be achieved, although the thickness is typically within a range from 1 µm to 100 µm.
This aluminum layer 25 may employ a sheet formed from a metallic foil such as an aluminum foil or an aluminum-iron alloy foil, an aluminum-vapor deposited PET sheet, or an aluminum foil-laminated PET sheet or the like.

The protective sheet 20B of the present embodiment yields similar effects to those described above for the protective sheet 20A of the first embodiment, and also provides improved moisture resistance as a result of the laminated aluminum layer 25.

As illustrated in FIG. 3, a solar cell module of the present invention has a structure in which the adhesive layer 24 of the above-mentioned protective sheet 20A or 20B is laminated to the back surface of the solar cell module 50 (to the surface of the encapsulant30 opposite the light-incident surface).
There are no particular limitations on the type or structure of this solar cell module 50, and examples include a-Si (amorphous silicon) solar cells, c-Si (crystalline silicon) solar cells, µc-Si (microcrystalline silicon) solar cells and compound semiconductor solar cells such as GaAs (gallium arsenide) solar cells, as well as dye-sensitized solar cells.

### EXAMPLES

Summaries of the materials used in the preparation of Examples 1 to 22 and Comparative Examples 1 to 6 described below are presented in Table 1.

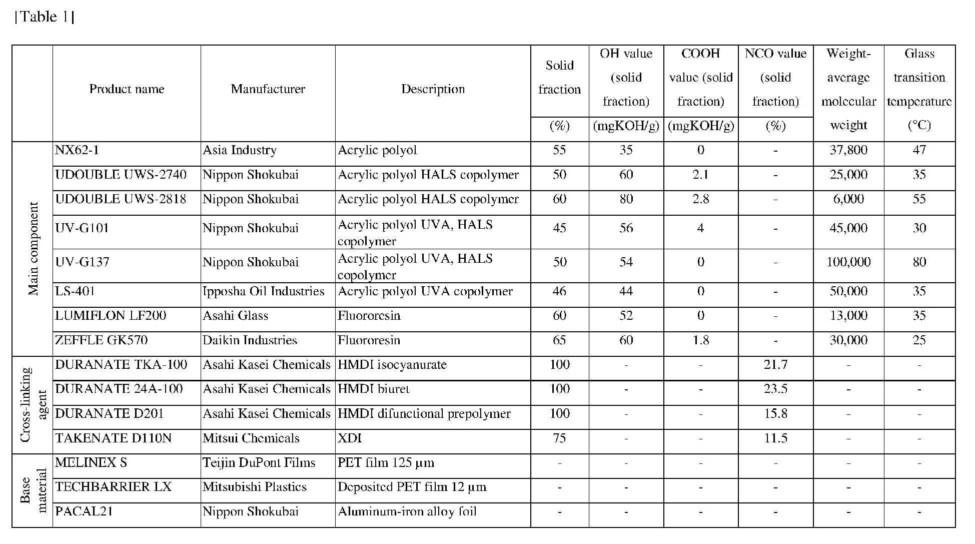

### [Preparation of coating liquid 1]

100 parts by mass of a polyester-modified acrylic polyol (product name: NX62-1, manufactured by Asia Industry Co., Ltd.) that represented the main component was blended with 79.5 parts by mass of methyl ethyl ketone (hereinafter abbreviated as "MEK") and 10.7 parts by mass of an HMDI isocyanurate cross-linking agent (product name: DURANATE TKA-100, manufactured by Asahi Kasei Chemicals Corporation) to prepare a coating liquid.

### [Preparation of coating liquids 2 to 14]

With the exception of altering the materials and blend amounts as shown in the columns labeled "Main component", "cross-linking agent" and "MEK" in Table 2, coating liquids 2 to 14 were prepared using the same preparation method as that described above for the coating liquid 1.

### Example 1

Using a PET film (product name: MELINEX S, manufactured by Teijin DuPont Films Ltd., thickness: 125 µm) as the base sheet, a bar coater was used to apply the coating liquid 1 to one surface of the base sheet, in an amount sufficient to form a coating layer with a dried coating thickness of 20 µm, and the coating layer was then dried at 120°C for one minute and subsequently left to stand for 7 days in an atmosphere at 23°C and 50% RH, thus yielding a protective sheet of Example 1.

### Example 2

With the exception of using the coating liquid 2 instead of the coating liquid 1, a protective sheet of Example 2 was prepared in the same manner as Example 1.

### Example 3

With the exception of using the coating liquid 3 instead of the coating liquid 1, a protective sheet of Example 3 was prepared in the same manner as Example 1.

### Example 4

With the exception of using the coating liquid 4 instead of the coating liquid 1, a protective sheet of Example 4 was prepared in the same manner as Example 1.

### Example 5

With the exception of using the coating liquid 5 instead of the coating liquid 1, a protective sheet of Example 5 was prepared in the same manner as Example 1.

### Example 6

With the exception of using the coating liquid 6 instead of the coating liquid 1, a protective sheet of Example 6 was prepared in the same manner as Example 1.

### Example 7

With the exception of using the coating liquid 7 instead of the coating liquid 1, a protective sheet of Example 7 was prepared in the same manner as Example 1.

### Example 8

With the exception of using the coating liquid 8 instead of the coating liquid 1, a protective sheet of Example 8 was prepared in the same manner as Example 1.

### Example 9

With the exception of using the coating liquid 9 instead of the coating liquid 1, a protective sheet of Example 9 was prepared in the same manner as Example 1.

### Example 10

With the exception of using the coating liquid 10 instead of the coating liquid 1, a protective sheet of Example 10 was prepared in the same manner as Example 1.

### Example 11

With the exception of using the coating liquid 11 instead of the coating liquid 1, a protective sheet of Example 11 was prepared in the same manner as Example 1.

### Example 12

With the exception of using the coating liquid 12 instead of the coating liquid 1, a protective sheet of Example 12 was prepared in the same manner as Example 1.

### Example 13

With the exceptions of using a silica-deposited PET film (product name: TECHBARRIER LX, manufactured by Mitsubishi Plastics, Inc.) as the base sheet, and using the coating liquid 2, a protective sheet of Example 13 was prepared in the same manner as Example 1.

### Example 14

With the exceptions of using a silica-deposited PET film (product name: TECHBARRIER LX, manufactured by Mitsubishi Plastics, Inc.) as the base sheet, and using the coating liquid 6, a protective sheet of Example 14 was prepared in the same manner as Example 1.

### Example 15

With the exceptions of using a silica-deposited PET film (product name: TECHBARRIER LX, manufactured by Mitsubishi Plastics, Inc.) as the base sheet, and using the coating liquid 7, a protective sheet of Example 15 was prepared in the same manner as Example 1.

### Example 16

With the exceptions of using a silica-deposited PET film (product name: TECHBARRIER LX, manufactured by Mitsubishi Plastics, Inc.) as the base sheet, and using the coating liquid 11, a protective sheet of Example 16 was prepared in the same manner as Example 1.

### Example 17

With the exceptions of using a silica-deposited PET film (product name: TECHBARRIER LX, manufactured by Mitsubishi Plastics, Inc.) as the base sheet, and using the coating liquid 12, a protective sheet of Example 17 was prepared in the same manner as Example 1.

### Example 18

With the exceptions of using an aluminum-iron alloy foil (product name: PACAL21, manufactured by Nippon Foil Mfg. Co., Ltd.) as the base sheet, and using the coating liquid 2, a protective sheet of Example 18 was prepared in the same manner as Example 1.

### Example 19

With the exceptions of using an aluminum-iron alloy foil (product name: PACAL21, manufactured by Nippon Foil Mfg. Co., Ltd.) as the base sheet, and using the coating liquid 6, a protective sheet of Example 19 was prepared in the same manner as Example 1.

### Example 20

With the exceptions of using an aluminum-iron alloy foil (product name: PACAL21, manufactured by Nippon Foil Mfg. Co., Ltd.) as the base sheet, and using the coating liquid 7, a protective sheet of Example 20 was prepared in the same manner as Example 1.

### Example 21

With the exceptions of using an aluminum-iron alloy foil (product name: PACAL21, manufactured by Nippon Foil Mfg. Co., Ltd.) as the base sheet, and using the coating liquid 11, a protective sheet of Example 21 was prepared in the same manner as Example 1.

### Example 22

With the exceptions of using an aluminum-iron alloy foil (product name: PACAL21, manufactured by Nippon Foil Mfg. Co., Ltd.) as the base sheet, and using the coating liquid 12, a protective sheet of Example 22 was prepared in the same manner as Example 1.

### Comparative Example 1

With the exception of using the fluororesin-based coating liquid 13 instead of the coating liquid 1, a protective sheet of Comparative Example 1 was prepared in the same manner as Example 1.

### Comparative Example 2

With the exception of using the fluororesin-based coating liquid 14 instead of the coating liquid 1, a protective sheet of Comparative Example 2 was prepared in the same manner as Example 1.

### Comparative Example 3

With the exceptions of using a silica-deposited PET film (product name: TECHBARRIER LX, manufactured by Mitsubishi Plastics, Inc.) as the base sheet, and using the fluororesin-based coating liquid 13, a protective sheet of Comparative Example 3 was prepared in the same manner as Example 1.

### Comparative Example 4

With the exceptions of using a silica-deposited PET film (product name: TECHBARRIER LX, manufactured by Mitsubishi Plastics, Inc.) as the base sheet, and using the fluororesin-based coating liquid 14, a protective sheet of Comparative Example 4 was prepared in the same manner as Example 1.

### Comparative Example 5

With the exceptions of using an aluminum-iron alloy foil (product name: PACAL21, manufactured by Nippon Foil Mfg. Co., Ltd.) as the base sheet, and using the fluororesin-based coating liquid 13, a protective sheet of Comparative Example 5 was prepared in the same manner as Example 1.

### Comparative Example 5

With the exceptions of using an aluminum-iron alloy foil (product name: PACAL21, manufactured by Nippon Foil Mfg. Co., Ltd.) as the base sheet, and using the fluororesin-based coating liquid 14, a protective sheet of Comparative Example 6 was prepared in the same manner as Example 1.

The protective sheets prepared in the manner described above were each evaluated for adhesion, durability and weather resistance (yellowing and elongation) using the evaluation methods described below, and the results were compared. The results are summarized in Table 2.

### <Adhesion evaluation>

For each of the protective sheets prepared in Examples 1 to 22 and Comparative Examples 1 to 6, a 10×10 cross-cut pattern of 1 mm squares was formed in the coating layer in accordance with JIS K5600-5-6, a cellophane pressure-sensitive adhesive tape (product name: CT-24, manufactured by Nichiban Co., Ltd.) was stuck to the coating layer, and the degree of detachment of the coating layer upon peeling of the tape was evaluated. The result was recorded as the number of squares among the 100 squares that did not detach upon peeling, so that absolutely no detachment of the coating layer yielded a result of 100, whereas complete detachment yielded a result of 0. The results of these adhesion evaluations are shown in Table 2 in the column labeled "0 hours" under the heading of "Adhesion (durability)".

### <Durability evaluation>

Each of the protective sheets prepared in Examples 1 to 22 and Comparative Examples 1 to 6 was placed in an atmosphere at 121°C and 100% RH (2 atm), and the adhesion was evaluated after 24 hours and after 48 hours under these conditions. The method used for evaluating the adhesion was the same as that described above in the section entitled <Adhesion evaluation>. The results of these durability evaluations are shown in Table 2 in the columns labeled "24 hours" and "48 hours" under the heading of "Adhesion (durability)".

### <Weather resistance evaluation>

Of the prepared protective sheets, weather resistance evaluations were performed for the protective sheets of Examples 2, 6, 7, 11 and 12, and Comparative Examples 1 and 2. Using a weather resistance tester (7.5 kW Super Xenon Weather Meter SX75, manufactured by Suga Test Instruments Co., Ltd.), the coating layer was irradiated for 1,000 hours under the conditions listed below, and the yellowing and elongation of the protective sheet were then measured.
Black panel temperature: 63°C (chamber humidity: 50% RH)
Irradiance: 60 W/m² (wavelength: 300 to 400 nm)
Water spray: 18 minutes per 120 minutes (sprayed water)

### <Yellowing>

Using a colorimeter (SQ2000, manufactured by Nippon Denshoku Industries Co., Ltd.) with a C/2 light source, the amount of change in the b* value (Δb*) of the coating surface was measured in accordance with JIS Z8730. The evaluation criteria used are listed below.
○: Δb* < 2
△: 2 ≤ Δb* ≤ 4
×: 4 < Δb*

### <Elongation>

The elongation was measured in accordance with JIS K7127-1999 at a test speed of 200 mm/minute, and the percentage change from the initial elongation value was calculated. The evaluation criteria used are listed below.
○: Reduction in elongation of less than 30%
×: Reduction in elongation of at least 30%

**Table 2**

| | Base material | Coating liquid | Main component | | | Cross-linking agent | | | MEK | Adhesion (durability) | | | Weather resistance evaluation | |
|---|---|---|---|---|---|---|---|---|---|---|---|---|---|---|
| | Product name | | Product name | Description | Parts by mass | Product name | Description | Parts by mass | Parts by mass | 0 hours | 24 hours | 48 hours | Yellowing | Elongation |
| Example 1 | Melinex S | Coating liquid 1 | NX62-1 | Acrylic polyol | 100 | TKA-100 | HMDI isocyanurate | 10.7 | 79.5 | 100 | 100 | 42 | - | - |
| Example 2 | Melinex S | Coating liquid 2 | UWS-2740 | HALS | 100 | TKA-100 | HMDI isocyanurate | 10.6 | 53.2 | 100 | 100 | 44 | △ | ○ |
| Example 3 | Melinex S | Coating liquid 3 | UWS-2740 | HALS | 100 | 24A-100 | HMDI biuret | 32.5 | 72.9 | 100 | 100 | 19 | - | - |
| Example 4 | Melinex S | Coating liquid 4 | UWS-2740 | HALS | 100 | D201 | HMDI difunctional prepolymer | 14.6 | 60.0 | 100 | 100 | 0 | - | - |
| Example 5 | Melinex S | Coating liquid 5 | UWS-2740 | HALS | 100 | D110N | XDI | 26.7 | 62.6 | 100 | 100 | 12 | - | - |
| Example 6 | Melinex S | Coating liquid 6 | UWS-2818 | HALS | 100 | TKA-100 | HMDI isocyanurate | 17.0 | 91.1 | 100 | 100 | 42 | △ | ○ |
| Example 7 | Melinex S | Coating liquid 7 | UV-G101 | UVA,HALS | 100 | TKA-100 | HMDI isocyanurate | 9.2 | 77.9 | 100 | 100 | 30 | ○ | ○ |
| Example 8 | Melinex S | Coating liquid 8 | UV-G101 | UVA, HALS | 100 | 24A-100 | HMDI biuret | 28.2 | 110.2 | 100 | 100 | 41 | - | - |
| Example 9 | Melinex S | Coating liquid 9 | UV-G101 | UVA, HALS | 100 | D201 | HMDI difunctional prepolymer | 12.7 | 76.9 | 100 | 100 | 0 | - | - |
| Example 10 | Melinex S | Coating liquid 10 | UV-G101 | UVA, HALS | 100 | D110N | XDI | 23.3 | 45.6 | 100 | 100 | 19 | - | - |
| Example 11 | Melinex S | Coating liquid 11 | UV-G137 | UVA,HALS | 100 | TKA-100 | HMDI isocyanurate | 7.4 | 74.7 | 100 | 100 | 35 | ○ | ○ |
| Example 12 | Melinex S | Coating liquid 12 | LS-401 | UVA | 100 | TKA-100 | HMDI isocyanurate | 8.6 | 76.8 | 100 | 100 | 40 | ○ | ○ |
| Example 13 | Techbarrier LX | Coating liquid 2 | UWS-2740 | HALS | 100 | TKA-100 | HMDI isocyanurate | 10.6 | 53.2 | 100 | 0 | 0 | - | - |
| Example 14 | Techbarrier LX | Coating liquid 6 | UWS-2818 | HALS | 100 | TKA-100 | HMDI isocyanurate | 17.0 | 91.1 | 100 | 0 | 0 | - | - |
| Example 15 | Techbarrier LX | Coating liquid 7 | UV-G101 | UVA, HALS | 100 | TKA-100 | HMDI isocyanurate | 9.2 | 77.9 | 100 | 0 | 0 | - | - |
| Example 16 | Techbarrier LX | Coating liquid 11 | UV-G137 | UVA, HALS | 100 | TKA-100 | HMDI isocyanurate | 7.4 | 74.7 | 100 | 0 | 0 | - | - |
| Example 17 | Techbarrier LX | Coating liquid 12 | LS-401 | UVA | 100 | TKA-100 | HMDI isocyanurate | 8.6 | 76.8 | 100 | 0 | 0 | - | - |
| Example 18 | PACAL21 | Coating liquid 2 | UWS-2740 | HALS | 100 | TKA-100 | HMDI isocyanurate | 10.6 | 53.2 | 100 | 100 | 100 | - | - |
| Example 19 | PACAL21 | Coating liquid 6 | UWS-2818 | HALS | 100 | TKA-100 | HMDI isocyanurate | 17.0 | 91.1 | 100 | 100 | 100 | - | - |
| Example 20 | PACAL21 | Coating liquid 7 | UV-G101 | UVA, HALS | 100 | TKA-100 | HMDI isocyanurate | 9.2 | 77.9 | 100 | 100 | 100 | - | - |
| Example 21 | PACAL21 | Coating liquid 11 | UV-G137 | UVA, HALS | 100 | TKA-100 | HMDI isocyanurate | 7.4 | 74.7 | 100 | 100 | 100 | - | - |
| Example 22 | PACAL21 | Coating liquid 12 | LS-401 | UVA | 100 | TKA-100 | HMDI isocyanurate | 8.6 | 76.8 | 100 | 100 | 100 | - | - |
| Comparative Example 1 | Melinex S | Coating liquid 13 | LF-200 | Fluororesin | 100 | TKA-100 | HMDI isocyanurate | 10.7 | 80.3 | 100 | 100 | 100 | △ | × |
| Comparative Example 2 | Melinex S | Coating liquid 14 | GK-570 | Fluororesin | 100 | TKA-100 | HMDI isocyanurate | 14.0 | 99.4 | 100 | 100 | 100 | △ | × |
| Comparative Example 3 | Techbarrier LX | Coating liquid 13 | LF-200 | Fluororesin | 100 | TKA-100 | HMDI isocyanurate | 10.7 | 80.3 | 100 | 0 | 0 | - | - |
| Comparative Example 4 | Techbarrier LX | Coating liquid 14 | GK-570 | Fluororesin | 100 | TKA-100 | HMDI isocyanurate | 14.0 | 99.4 | 100 | 0 | 0 | - | - |
| Comparative Example 5 | PACAL21 | Coating liquid 13 | LF-200 | Fluororesin | 100 | TKA-100 | HMDI isocyanurate | 10.7 | 80.3 | 100 | 100 | 100 | - | - |
| Comparative Example 6 | PACAL21 | Coating liquid 14 | GK-570 | Fluororesin | 100 | TKA-100 | HMDI isocyanurate | 14.0 | 99.4 | 100 | 100 | 100 | - | - |

Based on the results of Table 2 it was evident that, compared with the protective sheets of Comparative Examples 1 to 6 containing a fluororesin-based coating material, the protective sheets of Examples 1 to 22 according to the present invention exhibited similar or superior adhesion and durability.
Further, compared with the protective sheets of Comparative Examples 1 to 6 containing a fluororesin-based coating material, the protective sheets of Examples 1 to 22 according to the present invention were less prone to yellowing, retained favorable elongation, and exhibited excellent weather resistance.
The protective sheets of Examples 1 to 22 according to the present invention contain no halogens such as fluorine, can be incinerated when discarded, and are expected to have a considerably smaller environmental impact than the protective sheets of Comparative Examples 1 to 6 containing a fluororesin coating layer.
Accordingly, the present invention is able to provide a protective sheet that has minimal environmental impact and exhibits excellent adhesion to base sheets and excellent weather resistance.

### INDUSTRIAL APPLICABILITY

The protective sheet of the present invention contains no halogens such as fluorine, can be incinerated when discarded, has minimal environmental impact, and exhibits excellent adhesion to base sheets and excellent weather resistance. Accordingly, a solar cell module having a protective sheet of the present invention bonded thereto has similar or superior weather resistance and durability to a conventional protective sheet containing a fluororesin layer, and the protective sheet can be incinerated when discarded, meaning the environmental impact is minimal.

### DESCRIPTION OF THE REFERENCE SIGNS

10: Front surface protective sheet
20: Back surface protective sheet
20A, 20B: Protective sheet (protective sheet for solar cell module)
21: Acrylic urethane resin layer
22: Base sheet
23: Laminate adhesive layer
24: Adhesive layer
25: Aluminum layer
30: Encapsulant
40: Solar cell
50: Solar cell module

## Claims

1. A protective sheet for a solar cell module, the protective sheet prepared by forming an acrylic urethane resin layer on one surface or both surfaces of a base sheet.

2. The protective sheet for a solar cell module according to claim 1, wherein the acrylic urethane resin layer is formed on an opposite surface of the base sheet to a surface that contacts an encapsulant.

3. The protective sheet for a solar cell module according to claim 1, wherein the acrylic urethane resin layer is formed from a resin obtained by mixing and reacting an acrylic polyol and a polyisocyanate.

4. The protective sheet for a solar cell module according to claim 3, wherein the acrylic polyol has a weight-average molecular weight within a range from 5,000 to 300,000 and a glass transition temperature within a range from 30 to 80°C.

5. The protective sheet for a solar cell module according to claim 3, wherein a hydroxyl value of the acrylic polyol is within a range from 25 to 150 mgKOH/g (solid fraction).

6. The protective sheet for a solar cell module according to claim 3, wherein the acrylic polyol is a polyester-modified acrylic polyol.

7. The protective sheet for a solar cell module according to claim 3, wherein the acrylic polyol comprises one or both of an ultraviolet-stabilizing group and an ultraviolet-absorbing group within each molecule.

8. The protective sheet for a solar cell module according to claim 3, wherein a molar ratio within the acrylic urethane resin layer between isocyanate groups of the polyisocyanate component and hydroxyl groups of the acrylic polyol component ([NCO]/[OH]) is within a range from 0.5 to 1.5.

9. The protective sheet for a solar cell module according to claim 3, wherein the polyisocyanate is a hexamethylene diisocyanate-based polyisocyanate, and comprises one or more polyisocyanates selected from the group consisting of biuret-type, isocyanurate-type, adduct-type, difunctional prepolymer-type and block-type polyisocyanates.

10. The protective sheet for a solar cell module according to claim 1, wherein the acrylic urethane resin layer is laminated to one surface of the base sheet, and an adhesive layer, comprising one material selected from the group consisting of ethylene-vinyl acetate copolymers, ethylene-methacrylic acid copolymers, ionomer resins prepared by cross-linking molecules of an ethylene-methacrylic acid copolymer with metal ions, and mixtures thereof, is laminated to another surface of the base sheet with a laminate adhesive layer disposed therebetween.

11. The protective sheet for a solar cell module according to claim 1, wherein the acrylic urethane resin layer is laminated to one surface of the base sheet, an aluminum layer is laminated to another surface of the base sheet with a laminate adhesive layer disposed therebetween, and an adhesive layer, comprising one material selected from the group consisting of ethylene-vinyl acetate copolymers, ethylene-methacrylic acid copolymers, ionomer resins prepared by cross-linking molecules of an ethylene-methacrylic acid copolymer with metal ions, and mixtures thereof, is laminated to the aluminum layer with a laminate adhesive layer disposed therebetween.

12. A solar cell module, comprising the protective sheet for a solar cell module according to claim 1 bonded thereto.
